(19) Europäisches Patentamt / European Patent Office / Office européen des brevets

(11) **EP 4 435 143 A2**

(12) **EUROPEAN PATENT APPLICATION**

(43) Date of publication:
**25.09.2024 Bulletin 2024/39**

(21) Application number: **24165077.9**

(22) Date of filing: **21.03.2024**

(51) International Patent Classification (IPC):
**C23C 16/02** (2006.01)    **C23C 16/04** (2006.01)
**C23C 16/40** (2006.01)    **C23C 16/455** (2006.01)
**C23C 16/52** (2006.01)    **H01L 21/02** (2006.01)

(52) Cooperative Patent Classification (CPC):
**C23C 16/045; C23C 16/0272; C23C 16/04;
C23C 16/402; C23C 16/405; C23C 16/45527;
C23C 16/45553; C23C 16/52; H01L 21/0228**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **24.03.2023 JP 2023047530**

(71) Applicant: **Kokusai Electric Corp.
Tokyo 1010045 (JP)**

(72) Inventors:
• **OSANAI, Masanao
Toyama-shi, Toyama, 939-2393 (JP)**
• **NISHIDA, Keigo
Toyama-shi, Toyama, 939-2393 (JP)**

(74) Representative: **Bardehle Pagenberg
Partnerschaft mbB
Patentanwälte Rechtsanwälte
Prinzregentenplatz 7
81675 München (DE)**

(54) **METHOD OF PROCESSING SUBSTRATE, METHOD OF MANUFACTURING SEMICONDUCTOR DEVICE, PROGRAM, AND SUBSTRATE PROCESSING APPARATUS**

(57)    There is provided a technique that includes: forming an oxide film containing a predetermined element over a substrate (200) by performing a first cycle a first predetermined number of times, the cycle including: (a) forming a first layer containing the predetermined element terminated with a halogen element over the substrate (200) by supplying a first precursor containing the predetermined element and the halogen element to the substrate (200); (b) forming a second layer containing the predetermined element over the substrate (200) by supplying a second precursor containing the predetermined element and a single amino group bonded to the predetermined element in one molecule to the substrate (200) over which the first layer is formed; and (c) oxidizing the second layer by supplying an oxidizing agent to the substrate (200) over which the second layer is formed.

FIG. 4

**Description**

CROSS-REFERENCE TO RELATED APPLICATION

This application is based upon and claims the benefit of priority from Japanese Patent Application No. 2023-047530, filed on March 24, 2023, the entire contents of which are incorporated herein by reference.

TECHNICAL FIELD

The present disclosure relates to a method of processing a substrate, a method of manufacturing a semiconductor device, a program, and a substrate processing apparatus.

BACKGROUND

In the related art, as a process of manufacturing a semiconductor device, a process of forming a film over a substrate may be performed.

SUMMARY

Some embodiments of the present disclosure provide a technique capable of improving a step coverage of a film formed over a substrate.
According to some embodiments of the present disclosure, there is provided a technique that includes: forming an oxide film containing a predetermined element over the substrate by performing a first cycle a first predetermined number of times, the cycle including: (a) forming a first layer containing the predetermined element terminated with a halogen element over the substrate by supplying a first precursor containing the predetermined element and the halogen element to the substrate; (b) forming a second layer containing the predetermined element over the substrate by supplying a second precursor containing the predetermined element and a single amino group bonded to the predetermined element in one molecule to the substrate over which the first layer is formed; and (c) oxidizing the second layer by supplying an oxidizing agent to the substrate over which the second layer is formed.

BRIEF DESCRIPTION OF DRAWINGS

The accompanying drawings, which are incorporated in and constitute a part of the specification, illustrate embodiments of the present disclosure.

FIG. 1 is a schematic configuration diagram of a vertical process furnace of a substrate processing apparatus suitably used in embodiments of the present disclosure, in which a portion of the process furnace is illustrated in a vertical cross-sectional view.
FIG. 2 is a schematic configuration diagram of the vertical process furnace of the substrate processing apparatus suitably used in embodiments of the present disclosure, in which a portion of the process furnace is illustrated in a cross-sectional view taken along line A-A in FIG. 1.
FIG. 3 is a schematic configuration diagram of a controller of a substrate processing apparatus suitably used in embodiments of the present disclosure, in which a control system of the controller is illustrated in a block diagram.
FIG. 4 is a diagram showing a processing sequence according to embodiments of the present disclosure.
FIG. 5A is a diagram showing adsorption locations of a first precursor supplied to a wafer in a recess structure of the wafer. FIG. 5B is a diagram showing adsorption locations of a second precursor supplied to the wafer after the supply of the first precursor starts in the recess structure of the wafer. FIG. 5C is a diagram showing an oxide film formed in the recess structure of the wafer by performing a cycle including a first precursor supply step, a second precursor supply step, and an oxidizing agent supply step a predetermined number of times.
FIG. 6 is a diagram showing an example of an oxide film formed in a recess structure of a wafer.
FIG. 7 is a diagram showing another example of an oxide film formed in a recess structure of a wafer.

DETAILED DESCRIPTION

Reference will now be made in detail to various embodiments, examples of which are illustrated in the accompanying drawings. In the following detailed description, numerous specific details are set forth in order to provide a thorough understanding of the present disclosure. However, it will be apparent to one of ordinary skill in the art that the present disclosure may be practiced without these specific details. In other instances, well-known methods, procedures, systems, and components are not described in detail so as not to unnecessarily obscure aspects of the various embodiments.

<Embodiments of the Present Disclosure>

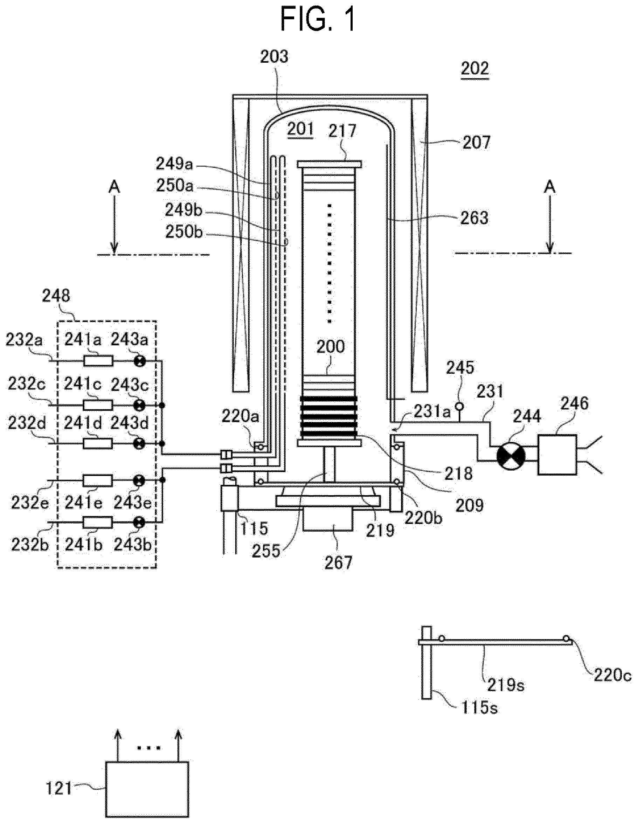

Hereinafter, embodiments of the present disclosure will be described mainly with reference to FIGS. 1 to 7. The drawings used in the following description are schematic, and the dimensional relationships, ratios, and the like of the respective components shown in the drawings may not match actual ones. Further, dimensional relationships, ratios, and the like of the respective components among plural drawings may not match one another.

(1) Configuration of Substrate Processing Apparatus

As shown in FIG. 1, a process furnace 202 includes a heater 207 as a temperature regulator (heating part). The heater 207 is formed in a cylindrical shape and is vertically installed by being supported by a holding plate. The heater 207 functions as an activator (an exciter) configured to activate (excite) a gas thermally.

A reaction tube 203 is disposed inside the heater 207 to be concentric with the heater 207. The reaction tube 203 is made of, for example, heat resistant material such as quartz ($SiO_2$) or silicon carbide (SiC), and is formed in a cylindrical shape with its upper end closed and its lower end opened. A manifold 209 is disposed to be concentric with the reaction tube 203 under the reaction tube 203. The manifold 209 is made of, for example, metal material such as stainless steel (SUS), and is formed in a cylindrical shape with both of its upper and lower ends opened. The upper end of the manifold 209 engages with the lower end of the reaction tube 203 to support the reaction tube 203. An O-ring 220a serving as a seal is provided between the manifold 209 and the reaction tube 203. Similar to the heater 207, the reaction tube 203 is vertically installed. A process container (reaction container) mainly includes the reaction tube 203 and the manifold 209. A process chamber 201 is formed in a hollow cylindrical area of the process container. The process chamber 201 is configured to be capable of accommodating wafers 200 as substrates. The wafers 200 are processed in the process chamber 201.

Nozzles 249a and 249b as first and second suppliers are installed in the process chamber 201 to penetrate a side wall of the manifold 209. The nozzles 249a and 249b are also referred to as a first nozzle and a second nozzle, respectively. The nozzles 249a and 249b are made of, for example, a heat-resistant material such as quartz or SiC. Each of the nozzles 249a and 249b is constituted as a shared nozzle used to supply multiple types of gas.

Gas supply pipes 232a and 232b as first and second pipes are connected to the nozzles 249a and 249b, respectively. Each of the gas supply pipes 232a and 232b is constituted as a shared pipe used to supply multiple types of gas. Mass flow controllers (MFCs) 241a and 241b as flow rate controllers (flow rate control parts) and valves 243a and 243b as opening/closing valves are installed at the gas supply pipes 232a and 232b, respectively, sequentially from the upstream side of a gas flow. Gas supply pipes 232c and 232d are respectively connected to the gas supply pipe 232a at the downstream side of the valve 243a. MFCs 241c and 241d and valves 243c and 243d are respectively installed at the gas supply pipes 232c and 232d, respectively, sequentially from the upstream side of a gas flow. A gas supply pipe 232e is connected to the gas supply pipe 232b at the downstream side of the valve 243b. A MFC 241e and a valve 243e are installed at the gas supply pipe 232e sequentially from the upstream side of a gas flow. The gas supply pipes 232a to 232e are made of, for example, a metallic material such as SUS (stainless steel).

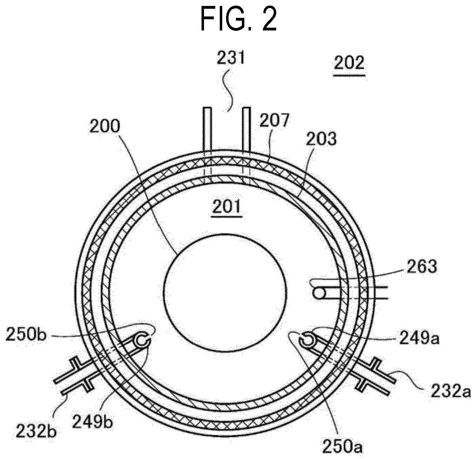

As shown in FIG. 2, each of the nozzles 249a and 249b is installed in an annular space in a plane view between an inner wall of the reaction tube 203 and the wafers 200 to extend upward from a lower side to an upper side of the inner wall of the reaction tube 203, that is, along an arrangement direction of the wafers 200. Specifically, each of the nozzles 249a and 249b is installed in a region horizontally surrounding a wafer arrangement region in which the wafers 200 are arranged at a lateral side of the wafer arrangement region, along the wafer arrangement region. Gas supply holes 250a and 250b configured to supply gases are formed on the side surfaces of the nozzles 249a and 249b, respectively. Each of the gas supply holes 250a and 250b is opened toward the centers of the wafers 200 in the plane view, which enables the gases to be supplied toward the wafers 200. The gas supply holes 250a and 250b are formed from the lower side to the upper side of the reaction tube 203.

A first precursor as a modifying agent and a film-forming agent is supplied from the gas supply pipe 232a into the process chamber 201 via the MFC 241a, the valve 243a, and the nozzle 249a.

An oxidizing agent as a film-forming agent is supplied from the gas supply pipe 232b into the process chamber 201 via the MFC 241b, the valve 243b, and the nozzle 249b.

A second precursor as a film-forming agent is supplied from the gas supply pipe 232c into the process chamber 201 via the MFC 241c, the valve 243c, and the nozzle 249a.

An inert gas is supplied from the gas supply pipes 232d and 232e into the process chamber 201 via the MFCs 241d and 241e, the valves 243d and 243e, the gas supply pipes 232a and 232b, and the nozzles 249a and 249b, respectively. The inert gas acts as a purge gas, a carrier gas, a dilution gas, or the like.

A first precursor supply system mainly includes the gas supply pipe 232a, the MFC 241a, and the valve 243a. An oxidizing agent supply system mainly includes the gas supply pipe 232b, the MFC 241b, and valve 243b. A second precursor supply system mainly includes the gas supply pipe 232c, the MFC 241c, and the valve 243c. An inert gas supply system mainly includes the gas supply pipes 232d and 232e, the MFCs 241d and 241e, and the valves 243d and 243e. The nozzles connected to the gas supply pipes constituting the various supply systems described above may be included in each of the supply systems.

Some or the entirety of the above-described various supply systems may be constituted as an integrated supply system 248 in which the valves 243a to 243e, the MFCs 241a to 241e and the like are integrated. The integrated supply system 248 is connected to each of the gas supply pipes 232a to 232e and is configured such that operations of supplying various materials (various gases) into the gas supply pipes 232a to 232e, that is, opening/closing operations of the valves 243a to 243e, flow rate regulation operations by the MFCs 241a to 241e, and the like are controlled by the controller 121 which will be described later. The integrated supply system 248 is constituted as an integral or detachable integrated unit, and may be attached to or detached from the gas supply pipes 232a to 232e and the like on an integrated unit basis, such that maintenance, replacement, expansion, and the like of the integrated supply system 248 may be performed on an integrated unit basis.

An exhaust port 231a configured to exhaust an internal atmosphere of the process chamber 201 is installed below the side wall of the reaction tube 203. As shown in FIG. 2, in the plane view, the exhaust port 231a is provided at a position opposing (facing) the nozzles 249a and 249b (gas supply holes 250a and 250b) with the wafers 200 interposed therebetween. The exhaust port 231a may be installed to extend from the lower side to the upper side of the side wall of the reaction tube 203, that is, along the wafer arrangement region. An exhaust pipe 231 is connected to the exhaust port 231a. A vacuum pump 246 as a vacuum exhauster is connected to the exhaust pipe 231 via a pressure sensor 245 as a pressure detector (pressure detection part) configured to detect an internal pressure of the process chamber 201, and an auto pressure controller (APC) valve 244 as a pressure regulator (pressure regulation part). The APC valve 244 is configured to be capable of performing or stopping a vacuum exhaust operation of the interior of the process chamber 201 by being opened or closed while the vacuum pump 246 is actuated, and is also configured to be capable of regulating the internal pressure of the process chamber 201 by adjusting an opening state of the valve based on pressure information detected by the pressure sensor 245 while the vacuum pump 246 is actuated. An exhaust system mainly includes the exhaust pipe 231, the APC valve 244, and the pressure sensor 245. The exhaust system may include the vacuum pump 246.

A seal cap 219, which serves as a furnace opening lid configured to be capable of hermetically sealing a lower end opening of the manifold 209, is installed under the manifold 209. The seal cap 219 is made of, for example, a metallic material such as SUS, and is formed in a disc shape. An O-ring 220b, which is a seal making contact with the lower end of the manifold 209, is installed on an upper surface of the seal cap 219. A rotator 267 configured to rotate a boat 217 to be described later is installed under the seal cap 219. A rotary shaft 255 of the rotator 267 is connected to the boat 217 through the seal cap 219. The rotator 267 is configured to rotate the wafers 200 by rotating the boat 217. The seal cap 219 is configured to be vertically raised or lowered by a boat elevator 115 as an elevator installed outside the reaction tube 203. The boat elevator 115 is constituted as a transporter (transport mechanism) configured to load or unload (transport) the wafers 200 into or out of the process chamber 201 by raising or lowering the seal cap 219.

A shutter 219s as a furnace opening lid configured to be capable of hermetically sealing the lower end opening of the manifold 209 in a state where the seal cap 219 is lowered and the boat 217 is unloaded from the process chamber 201, is installed under the manifold 209. The shutter 219s is made of, for example, a metallic material such as SUS, and is formed in a disc shape. An O-ring 220c as a seal making contact with the lower end of the manifold 209 is installed on the upper surface of the shutter 219s. The opening/closing operation (elevating operation, rotating operation, or the like) of the shutter 219s are controlled by a shutter opening/closing mechanism 115s.

A boat 217 as a substrate support is configured to support a plurality of wafers 200, for example, 25 to 200 wafers 200 in such a state that the wafers 200 are arranged in horizontal posture and in multiple stages along a vertical direction with the centers of the wafers 200 aligned with one another. That is, the boat 217 is configured to arrange the wafers 200 to be spaced apart from each other. The boat 217 is made of, for example, a heat-resistant material such as quartz or SiC. Heat insulating plates 218 made of, for example, a heat-resistant material such as quartz or SiC are supported below the boat 217 in multiple stages.

A temperature sensor 263 as a temperature detector is installed in the reaction tube 203. Based on temperature information detected by the temperature sensor 263, a state of supplying an electric power to the heater 207 is regulated such that a temperature distribution inside the process chamber 201 becomes a desired temperature distribution. The temperature sensor 263 is installed along the inner wall of the reaction tube 203.

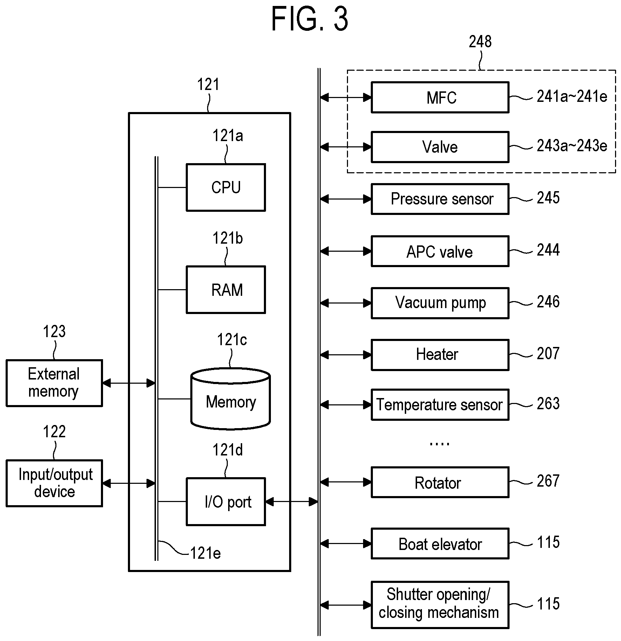

As shown in FIG. 3, a controller 121 as a control part (control means or unit) is constituted as a computer including a central processing unit (CPU) 121a, a random access memory (RAM) 121b, a memory 121c and an I/O port 121d. The RAM 121b, the memory 121c, and the I/O port 121d are configured to be capable of exchanging data with the CPU 121a via an internal bus 121e. An input/output device 122 including, for example, a touch panel or the like is connected to the controller 121. Further, an external memory 123 may be connected to the controller 121. The substrate processing apparatus may be configured to include one controller, or may be configured to include a plurality of controllers. That is, a control to perform the processing sequence described below may be performed by using one controller, or may be performed by using a plurality of controllers. Further, the plurality of controllers may be constituted as a control system connected to one another via a wired or wireless communication network, or the entire control system may perform the control to perform the processing sequence described below. When the term "controller" is used in the present disclosure, it may include one controller, a plurality of controllers, or a control system constituted by a plurality of controllers.

The memory 121c includes, for example, a flash memory, a hard disk drive (HDD), a solid state drive (SSD), or the like. A control program that controls the operation of the substrate processing apparatus, a process recipe in which sequences and conditions of substrate processing process to be described below are written, and the like are readably stored in the memory 121c. The process recipe functions as a program configured to cause, by the controller 121, the substrate processing apparatus to perform the respective sequences in a below-described substrate processing process, to obtain a predetermined result. Hereinafter, the process recipe, the control program, and the like are generally and simply referred to as a "program." Furthermore, the process recipe may be simply referred to as a "recipe." When the term "program" is used herein, it may indicate a case of including the recipe, a case of including the control program, or a case of including both the recipe and the control program. The RAM 121b is constituted as a memory area (work area) in which programs, data and the like read by the CPU 121a are temporarily held.

The I/O port 121d is connected to the MFCs 241a to 241e, the valves 243a to 243e, the pressure sensor 245, the APC valve 244, the vacuum pump 246, the temperature sensor 263, the heater 207, the rotator 267, the boat elevator 115, the shutter opening/closing mechanism 115s, and the like.

The CPU 121a is configured to be capable of reading and executing the control program from the memory 121c and reading the recipe from the memory 121c in response to an input of an operation command from the input/output device 122 or the like. The CPU 121a is configured to be capable of controlling flow rate regulation operations of various materials (various gases) by the MFCs 241a to 241e, opening/closing operations of the valves 243a to 243e, an opening/closing operation of the APC valve 244, an pressure regulation operation performed by the APC valve 244 based on the pressure sensor 245, an operation of actuating or stopping the vacuum pump 246, a temperature regulation operation performed by the heater 207 based on the temperature sensor 263, operations of rotating the boat 217 and adjusting a rotation speed of the boat 217 with the rotator 267 , an operation of raising or lowering the boat 217 by the boat elevator 115, an opening/closing operation of the shutter 219s by the shutter opening/closing mechanism 115s, and the like, according to the contents of the read recipe.

The controller 121 may be constituted by installing, in the computer, the above-described program recorded and stored in an external memory 123. The external memory 123 includes, for example, a magnetic disk such as a HDD, an optical disc such as a CD, a magneto-optical disc such as a MO, a semiconductor memory such as a USB memory or a SSD, and so forth. The memory 121c and the external memory 123 are constituted as a computer-readable recording medium. Hereinafter, the memory 121c and the external memory 123 are generally and simply referred to as a recording medium. As used herein, the term "recording medium" may indicate a case of including the memory 121c, a case of including the external memory 123, or a case of including both the memory 121c and the external memory 123. The program may be installed to the computer by using a communication means or unit such as the Internet or a dedicated line instead of using the external memory 123.

(2) Substrate Processing Process

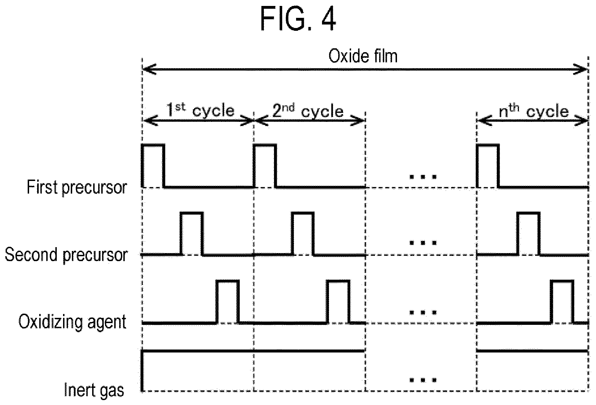

As a processes of manufacturing a semiconductor device by using the above-described substrate processing apparatus, a method of processing a substrate, i.e., an example of a processing sequence of forming an oxide film over a wafer 200 as the substrate, will be described mainly with reference to FIGS. 4 to 7. In the embodiments of the present disclosure, examples are described in which a wafer 200 including a recess structure 300 (such as a trench, a groove, or a hole, which is a three-dimensional structure) formed at the surface of the wafer 200 is used. In the following description, operations of the respective components constituting the substrate processing apparatus are controlled by the controller 121.

According to some embodiments of the present disclosure, a processing sequence includes forming an oxide film containing a predetermined element over the wafer 200 by performing a cycle a predetermined number of times (n times, where n is an integer of 1 or 2 or more), the cycle including:

(a) step A of forming a first layer containing the predetermined element terminated with a halogen element over the wafer 200 by supplying a first precursor containing the predetermined element and the halogen element to the wafer 200;

(b) step B of forming a second layer containing the predetermined element over the wafer 200 by supplying a second precursor containing the predetermined element and a single amino group bonded to the predetermined element in one molecule to the wafer 200 over which the first layer is formed; and

(c) step C of oxidizing the second layer by supplying an oxidizing agent to the wafer 200 over which the second layer is formed.

In the embodiments of the present disclosure, the predetermined element contained in the first precursor and the second precursor is a main element that constitutes the second layer and the oxide film formed over the wafer 200. Hereinafter, as an example, a case where a Si film is formed as a base over the surface of the wafer 200 will be described.

In the present disclosure, the above-mentioned processing sequence may be expressed as follows for the sake of convenience. Similar notations will be used in the following description of modifications and other embodiments.

(first precursor $\rightarrow$ purging $\rightarrow$ second precursor $\rightarrow$ purging $\rightarrow$ oxidizing agen $\rightarrow$ purging) $\times$ n

The term "wafer" used herein may refer to a wafer itself or a stacked body of a wafer and a predetermined layer or film formed over a surface of the wafer. The phrase "a surface of a wafer" used herein may refer to a surface of a wafer itself or a surface of a predetermined layer or the like formed over a wafer. The expression "a predetermined layer is formed over a wafer" used herein may mean that a predetermined layer is directly formed over a surface of a wafer itself or that a predetermined layer is formed over a layer or the like formed over a wafer. The term "substrate" used herein may be synonymous with the term "wafer."

As used herein, the term "agent" includes at least one selected from the group of a gaseous substance and a liquid substance. The liquid substance includes a mist-like substance. That is, each of the first precursor, the second precursor, and the oxidizing agent may include a gaseous substance, a liquid substance such as a mist-like substance or the like, or both.

As used herein, the term "layer" includes at least one selected from the group of a continuous layer and a discontinuous layer. For example, the first layer and the second layer may include continuous layers, discontinuous layers, or both.

In the present disclosure, the description that the first precursor, the second precursor, and the oxidizing agent are adsorbed to or react with the surface of the wafer 200 includes a case where the first precursor, the second precursor, and the oxidizing agent are adsorbed to or react with the surface of the wafer while remaining undecomposed, and a case where intermediates produced by decomposition of the first precursor, the second precursor, and the oxidizing agent or desorption of ligands of the first precursor, the second precursor, and the oxidizing agent are adsorbed to or react with the surface of the wafer 200.

(Wafer Charging and Boat Loading)

After the boat 217 is charged with a plurality of wafers 200 (wafer charging), the shutter 219s is moved by the shutter opening/closing mechanism 115s to open the lower end opening of the manifold 209 (shutter opening). Thereafter, as shown in FIG. 1, the boat 217 supporting the plurality of wafers 200 is lifted by the boat elevator 115 to be loaded into the process chamber 201 (boat loading). In this state, the seal cap 219 seals the lower end of the manifold 209 via the O-ring 220b. In this way, the wafers 200 are prepared (provided) inside the process chamber 201.

(Pressure Regulation and Temperature Regulation)

After the boat loading is completed, the inside of the process chamber 201, that is, a space where the wafers 200 are placed, is vacuum-exhausted (depression-exhausted) by the vacuum pump 246 to reach a desired pressure (state of vacuum). At this time, the internal pressure of the process chamber 201 is measured by the pressure sensor 245, and the APC valve 244 is feedback-controlled based on the measured pressure information. Further, the wafers 200 in the process chamber 201 are heated by the heater 207 to reach a desired processing temperature. At this time, a state of supplying electric power to the heater 207 is feedback-controlled based on the temperature information detected by the temperature sensor 263 such that a temperature distribution inside the process chamber 201 becomes a desired temperature distribution. Further, the rotation of the wafers 200 by the rotator 267 is started. The exhaust of the inside of the process chamber 201 and the heating and rotation of the wafers 200 are continuously performed at least until the processing on the wafers 200 is completed.

(Film-forming Process)

Thereafter, the following steps A, B and C are executed sequentially.

[Step A]

In this step, a first precursor containing a predetermined element and a halogen element is supplied to the wafers 200 in the process chamber 201.

Specifically, the valve 243a is opened to allow the first precursor to flow through the gas supply pipe 232a. A flow rate of the first precursor is regulated by the MFC 241a. The first precursor is supplied into the process chamber 201 via the nozzle 249a, and is exhausted via the exhaust port 231a. At this time, the first precursor is supplied to the wafers 200 (supply of first precursor). In this operation, the valves 243d and 243e may be opened to supply an inert gas into the process chamber 201 via the nozzles 249a and 249b.

A processing condition when supplying the first precursor in this step is exemplified as follows.

Processing temperature: 350 to 700 degrees C, specifically 500 to 600 degrees C
Processing pressure: 1 to 10,000 Pa, specifically 10 to 1,333 Pa
Supply flow rate of first precursor: 0.01 to 3 slm, specifically 0.1 to 1 slm
Supply time of first precursor: 10 to 120 seconds, specifically 20 to 60 seconds
Supply flow rate of inert gas (for each gas supply pipe): 0 to 10 slm

The processing pressure in this step may be lower than the processing pressure in step B. Further, a partial pressure of the first precursor supplied to the wafers 200 in this step may be lower than a partial pressure of the second precursor supplied to the wafers 200 in step B. From the viewpoint of improving a processing speed, the processing temperature may be substantially the same in steps A to C. In addition, when a precursor containing a bond between the predetermined elements (where two elements are both the predetermined element) is used as the first precursor, in this step, the first precursor may be supplied to the wafers 200 under a processing condition in which the bond of the predetermined elements contained in the first precursor is broken in a gas phase. The processing condition mentioned above includes at least one selected from the group of a processing temperature, a processing pressure, presence or absence of plasma excitation, and a magnitude of energy given during plasma excitation.

In the present disclosure, notation of a numerical range such as "350 to 700 degrees C" means that a lower limit and an upper limit are included in that range. Therefore, for example, "350 to 700 degrees C" means "350 degrees C or more and 700 degrees C or less." The same applies to other numerical ranges. Further, a processing temperature in the present disclosure means a temperature of the wafers 200 or an internal temperature of the process chamber 201, and a processing pressure means an internal pressure of the process chamber 201, that is, a pressure of the space where the wafers 200 are placed. Further, a processing time means a time during which the processing is continued. In addition, in a case where the supply flow rate includes 0 slm, 0 slm means that the substance (gas) is not supplied. The same applies to the following description.

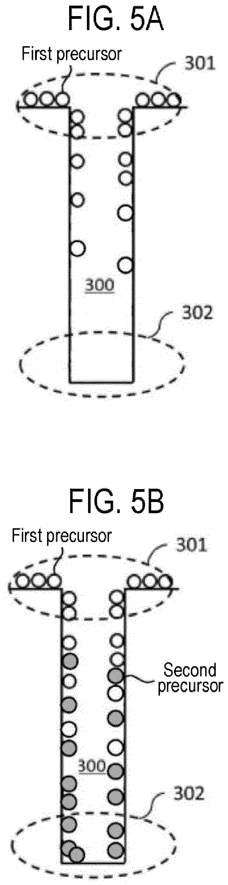

By supplying the first precursor containing the predetermined element and the halogen element to the wafers 200 under the above-described processing condition, the first precursor is adsorbed to the surface of the wafer 200, it is possible to form a first layer containing the predetermined element and including a surface terminated with the halogen element *(see* FIG. 5A). Specifically, under the above-mentioned processing condition, the bond between the predetermined element and the halogen element in the first precursor may be partially broken, and the predetermined element containing dangling bonds may be adsorbed to the adsorption sites on the surface of the wafer 200 to form the first layer. In addition, when a precursor containing the bond between the predetermined elements is used as the first precursor, under the above-mentioned processing condition, the bond between the predetermined elements contained in the first precursor may be broken, and the predetermined element containing dangling bonds may be adsorbed to the adsorption sites on the surface of the wafer 200 to form the first layer.

When the surface of the wafer 200 is constituted by an oxide film, for example, terminations such as OH terminations are present as the adsorption sites on the surface of the wafer 200. By forming the first layer in this step, the adsorption sites on the surface of the wafer 200 are at least partially occupied by the halogen-terminated first layer. Further, in step C, which will be described later, an oxidizing agent is supplied to the wafer 200, such that terminations such as OH terminations, which becomes adsorption sites in steps A and B, are formed over the outermost surface of the wafer 200.

Under the above-mentioned processing condition, a first layer containing a predetermined element and containing terminations of a halogen element (halogen terminations) formed over a surface of the first layer may be discontinuously formed over an upper surface and at least a portion of an inner surface of the recess structure 300 (specifically, side and bottom surfaces inside the recess structure 300). Specifically, the first precursor (predetermined element) may be adsorbed preferentially to an opening side 301 of the recess structure 300 to form the first layer *(see* FIG. 5A). In other words, the first layer may be formed such that a density of the first layer formed at an upper end of a side surface of the opening side 301 of the recess structure 300 (a side surface of an opening of the recess structure 300) is greater than a density of the first layer formed at a lower end of a deep side 302 of the recess structure 300 (a side surface of a lower end of the recess 300 and/or a bottom surface of the recess structure 300). In the present disclosure, "density of a layer" at the upper surface and the inner surface of the recess structure 300 may be synonymous with, for example, the number of adsorbed predetermined elements bonded with halogen elements (i.e., terminated with halogen elements) per unit area at the inner surface of the recess structure 300, or an average thickness of a layer per unit area at the inner surface of the recess structure 300. The first layer may be formed discontinuously over the entire inner surface of the recess structure 300.

In a case where the processing temperature is less than 350 degrees C, it may be difficult to enable chemical adsorption to the inner surface of the recess structure 300, and it may be difficult to form the first layer at a practical rate. By setting the processing temperature to 350 degrees C or higher, it becomes possible to form the first layer over the inner surface of the recess structure 300 at a practical rate.

Further, in a case where a precursor containing a bond between the predetermined elements is used as the first precursor, when the processing temperature is less than 500 degrees C, the bond between the predetermined elements contained in the first precursor may not be broken in the gas phase, such that it may be difficult for the predetermined element to be adsorbed to the inner surface of the recess structure 300. By setting processing temperature to 500 degrees C or higher, it is possible to break the bond between the predetermined elements contained in the first precursor and promote adsorption of the predetermined element to the inner surface of the recess structure 300.

In a case where the processing temperature exceeds 700 degrees C, the first precursor may be thermally decomposed excessively in the gas phase, and the predetermined element tends to be locally deposited near the upper end of the inner surface of the recess structure 300, which make it difficult to form a first layer with a desired layer thickness distribution on a side wall or a bottom surface of the inner surface of the recess structure 300. By setting the processing temperature to 700 degrees C or lower, it becomes possible to form a first layer with a desired layer thickness distribution on the side wall or the bottom surface of the inner surface of the recess structure 300. By setting the processing temperature to 600 degrees C or less, it becomes easier to form a first layer with a desired layer thickness distribution on the side wall or the bottom surface of the inner surface of the recess structure 300. In addition, when the same processing temperature is maintained in step C, which will be described later, by setting the processing temperature to 600 degrees C or less, it is possible to suppress excessive thermal decomposition of the oxidizing agent supplied in step C, and it is possible to achieve a practical deposition rate.

At the first layer, the halogen terminations formed over the surface of the first layer suppresses (inhibits) adsorption of at least one selected from the group of a second precursor supplied in below-described step B or predetermined element contained in the second precursor. In other words, the first layer constitutes an adsorption inhibition layer that inhibits adsorption of at least one selected from the group of the second precursor and the predetermined element contained in the second precursor to the first layer.

As the first precursor, a gas containing a predetermined element and a halogen element may be used. When the predetermined element is Si, a halosilane gas may be used as the first precursor. As the halogen element, at least one selected from the group of chlorine (Cl), fluorine (F), bromine (Br), and iodine (I) may be used.

As the first precursor, it may be possible to use a chlorosilane-based gas such as a tetrachlorosilane ($SiCl_4$) gas, a monochlorosilane ($SiH_3Cl$) gas, a dichlorosilane ($SiH_2Cl_2$) gas, or a trichlorosilane ($SiHCl_3$) gas, which does not contain any Si-Si bond (i.e., any bond between predetermined elements) in one molecule. As the first precursor, in addition to chlorosilane-based gas, it may be possible to use, for example, a fluorosilane-based gas such as a tetrafluorosilane ($SiF_4$) gas, a difluorosilane ($SiH_2F_2$) gas or the like, a bromosilane-based gas such as a tetrabromosilane ($SiBr_4$) gas, a dibromosilane ($SiH_2Br_2$) gas or the like, and an iodosilane-based gas such as a tetraiodosilane ($SiI_4$) gas, a diiodosilane ($SiH_2I_2$) gas or the like, which do not contain any Si-Si bond (i.e., any bond between predetermined elements) in one molecule. Among these gases, it is possible to use, as the first precursor, a gas that does not contain hydrogen (H) in one molecule, such as the $SiCl_4$ gas, the $SiF_4$ gas, the SiBr4 gas, and the $SiI_4$ gas.

In addition, as the first precursor, it may be possible to use a chlorosilane-based gas such as a hexachlorodisilane ($Si_2Cl_6$) gas, an octachlorotrisilane ($Si_3Cl_8$) gas, a monochlorodisilane ($Si_2H_5Cl$) gas, a dichlorodisilane ($Si_2H_4Cl_2$) gas, a trichlorodisilane ($Si_2H_3Cl_3$) gas, a tetrachlorodisilane ($Si_2H_2Cl_4$) gas, a monochlorotrisilane (SisHsCl) gas, a dichlorotrisilane ($Si_3H_4Cl_2$) gas or the like, which contains a Si-Si bond (i.e., a bond between predetermined elements) in one molecule. Further, as the first precursor, it may be possible to use other halosilane-based gases with molecular structures in which Cl atoms in molecular structures of these chlorosilane-based gases are replaced with atoms of other halogen elements. Among these gases, as the first precursor, it is possible to use a gas that does not contain H, such as the $Si_2Cl_6$ gas or the $Si_3Cl_8$ gas.

One or more of these gases may be used as the first precursor.

As the inert gas, it may be possible to use a nitrogen ($N_2$) gas, or a rare gas such as an argon (Ar) gas, a helium (He) gas, a neon (Ne) gas, a xenon (Xe) gas or the like. One or more of these gases may be used as the inert gas. The same applies to each step described later.

After the first layer is formed over the surface of the wafer 200 (the upper surface and the inner surface of the recess structure 300), the valve 243a is closed to stop the supply of the first precursor into the process chamber 201.

Then, the inside of the process chamber 201 is vacuum-exhausted to remove gaseous substances remaining inside the process chamber 201 from the inside of the process chamber 201. At this time, the valves 243d and 243e are opened to supply an inert gas into the process chamber 201 via the nozzles 249a and 249b. The inert gas supplied from the nozzles 249a and 249b acts as a purge gas, thereby purging the space where the wafers 200 exist, i.e., the inside of the process chamber 201.

[Step B]

After step A is completed, a second precursor containing a predetermined element and an amino group bonded to the predetermined element in one molecule is supplied to the wafer 200 in the process chamber 201, i.e., the wafer 200 in which the first layer is formed over the inner surface of the recess structure 300. In the embodiments of the present disclosure, a second precursor containing a predetermined element and a single amino group bonded to the predetermined element in one molecule is supplied. That is, the single amino group is a sole amino group which is bonded to the predetermined element in one molecule of the second precursor.

Specifically, the valve 243c is opened to allow the second precursor to flow through the gas supply pipe 232c. A flow rate of the second precursor is regulated by the MFC 241c. The second precursor is supplied into the process chamber 201 via the nozzle 249a, and is exhausted via the exhaust port 231a. At this time, the second precursor is supplied to the wafer 200 (supply of second precursor). At this time, the valves 243d and 243e may be opened to supply an inert gas into the process chamber 201 via the nozzles 249a and 249b respectively.

A processing condition when the second precursor is supplied in this step may be exemplified as follows.

Processing temperature: 20 to 700 degrees C, specifically 200 to 600 degrees C, more specifically 500 to 600 degrees C
Processing pressure: 1 to 10,000 Pa, specifically 10 to 2,666 Pa, more specifically 10,000 to 2,666 Pa
Supply flow rate of second precursor: 0.01 to 4 slm, specifically 0.3 to 1 slm
Supply time of second precursor: 1 to 60 seconds, specifically 5 to 20 seconds

Other processing conditions may be the same as those used when the first precursor is supplied in step A. However, this step is performed under a processing condition in which the predetermined element contained in the second precursor may be adsorbed to the wafer 200 by supplying the second precursor to the wafer 200 over which the first layer is not formed. The processing condition referred to herein include at least one selected from the group of a temperature condition and a pressure condition. Further, the processing pressure in this step may be higher than the processing pressure in step A. Moreover, a partial pressure of the second precursor supplied to the wafer 200 in this step is higher than a partial pressure of the first precursor supplied to the wafer 200 in step A.

By supplying the second precursor containing the predetermined element to the wafer 200 under the above-described processing condition, the second precursor may be mainly adsorbed to locations at the first layer over the surface of the wafer 200 where halogen terminations are not formed (i.e., adsorption sites remaining on the surface of the wafer 200, which are not terminated with halogen elements), thereby forming a second layer containing the predetermined element (see FIG. 5B). Specifically, the predetermined element, which contains dangling bonds due to desorption of the amino groups from molecules of the second precursor, is adsorbed to the adsorption sites on the surface of the wafer 200 over which the first layer is not formed, whereby the second layer may be formed over the wafer 200. When forming the second layer, the halogen elements terminating the first layer react with the amino groups contained in the second precursor, such that at least a portion of the halogen elements is desorbed from the surface of the wafer 200 (the surface of the first layer).

In a case where the first layer is not formed over the inner surface of the recess structure 300, a deposition rate of the second layer over the surface of the deep side 302 may be lower than a deposition rate of the second layer over the surface of the opening side 301 due to an imbalance in a supply amount of the second precursor, which may deteriorate a step coverage of the second layer. Further, as the step coverage of the second layer is deteriorated, a step coverage of the oxide film formed by modifying (oxidizing) the second layer may also be deteriorated.

However, as described above, the first layer that inhibits the adsorption of the second precursor is formed such that a density of the first layer becomes larger at an upper end of the opening side 301 than at a lower end of the deep side 302 (the bottom surface of the opening of the recess structure 300). Therefore, the adsorption of the second precursor is further suppressed at the opening side 301 than at the deep side 302. As a result, an action of the first layer reducing a density of the second layer is greater at the opening side 301 than at the deep side 302. Thus, the deposition rate of the second layer at the deep side 302 may be greater than the deposition rate of the second layer at the opening side 301, as compared with the case where the first layer is not formed. That is, by forming the first layer, a thickness distribution of the second layer may be controlled to increase the deposition rate of the second layer at the deep side 302 and reduce the deposition rate of the second layer at the opening side 301, as compared to the case where the first layer is not formed. For example, the thickness distribution of the second layer may be controlled such that the deposition rate of the second layer at the deep side 302 is higher than the deposition rate of the second layer at the opening side 301, or the deposition rate of the second layer at the deep side 302 and deposition rate of the second layer at the opening side 301 are substantially equal to each other.

In this step, in a case where the processing temperature is 500 degrees C or lower, it may be difficult for the predetermined element contained in the second precursor to be adsorbed to the inner surface of the recess structure 300, making it difficult to form the second layer at a practical rate. In this step, by setting the processing temperature to a temperature exceeding 500 degrees C, it becomes possible to form the second layer over the inner surface of the recess structure 300 at a practical rate.

Further, when the processing pressure is less than 100 Pa, the adsorption of the second precursor to the inner surface of the recess structure 300 becomes difficult to occur, which may make it difficult to form the second layer at a practical rate. By setting the processing pressure to 100 Pa or more, it is possible to promote the adsorption of the second precursor to the inner surface of the recess structure 300, thereby forming the second layer at a practical rate.

In this step, for example, by setting the processing temperature to a temperature exceeding 500 degrees C, and setting the processing pressure to 100 Pa or more, it is possible to achieve the processing conditions under which, the predetermined element contained in the second precursor may be adsorbed, at a practical rate, even to the surface of the wafer 200 over which the first layer is not formed.

Further, when the processing temperature exceeds 700 degrees C, the second precursor is thermally decomposed excessively in the gas phase, and the predetermined element tends to be locally deposited in multiple layers near the upper end of the inner surface of the recess structure 300, which may make it difficult to form the second layer with an excellent step coverage. By setting the processing temperature to 700 degrees C or lower, it is possible to form the second layer with an excellent step coverage.

As the second precursor, it may be possible to use a gas containing a predetermined element and an amino group bonded to the predetermined element in one molecule. That is, when the predetermined element is Si, an aminosilane-based gas may be used as the second precursor.

As the second precursor, it is possible to use a gas containing a predetermined element and a single amino group bonded to the predetermined element in one molecule. In other words, it is possible to use, as the second precursor, a precursor containing a compound represented by a chemical formula $AR1_{x-1}R2$, where A is the predetermined element, R1 is a ligand other than an amino group, R2 is an amino group, and x is the number of bonding hands of the predetermined element. For example, when the predetermined element is Si, it is possible to use, as the second precursor, an aminosilane-based gas containing Si and an amino group, in which a single amino group is bonded to one Si contained in one molecule. In addition, it is possible to use, as the second precursor, a gas containing a predetermined element and a single amino group bonded to the predetermined element in one molecule, in which among the bonding hands of the predetermined element, a bonding hand other than the bonding hand bonded to the single amino group is bonded to H. In other words, it is possible to use, as the second precursor, a precursor containing a compound represented by a chemical formula $AH_{x-1}R$ where A is the predetermined element, R is a single amino group, and x is the number of bonding hands of the predetermined element.

Here, the amino group refers to a functional group in which one or two hydrocarbon groups containing one or more carbon (C) atoms are coordinated to one nitrogen (N) atom (a functional group in which one H or both H's of the amino group represented by $NH_2$ is substituted with a hydrocarbon group containing one or more C atoms). When two hydrocarbon groups forming a part of an amino group are coordinated to one N, the two hydrocarbon groups may be the same hydrocarbon group or different hydrocarbon groups. The hydrocarbon groups may contain a single bond like an alkyl group, or may contain an unsaturated bond such as a double bond or triple bond. The amino group may contain a cyclic structure. Since the amino group is bonded to Si, which is a central atom of an aminosilane molecule, the amino group in aminosilane may also be referred to as a ligand or an amino ligand. The aminosilane-based gas may also contain a hydrocarbon group in addition to Si and an amino group. The hydrocarbon groups may contain a single bond like an alkyl group, or may contain an unsaturated bond such as a double bond or triple bond. The hydrocarbon groups may contain a cyclic structure. The hydrocarbon groups may be bonded to Si, which is a central atom of an aminosilane molecule, and in such a case, the hydrocarbon group in aminosilane may also be referred to as a ligand or a hydrocarbon ligand. When the hydrocarbon group is an alkyl group, the hydrocarbon group may also be referred to as an alkyl ligand.

As the second precursor, it may be possible to use an aminosilane-based gas including a (dialkylamino)trialkylsilane gas such as a (dimethylamino)trimethylsilane $((CH_3)_2NSi(CH_3)_3)$ gas, a diethylaminotrimethylsilane $((C_2H_5)_2NSi(CH_3)_3)$ gas, a diethylaminotriethylsilane $((C_2H_5)_2NSi(C_2H_5)_3)$ gas, a dimethylaminotriethylsilane $((CH_3)_2NSi(C_2H_5)_3)$ gas or the like, a mono(dialkylamino)silane gas such as a (diisobutylamino)silane $((C_4H_9)_2NSiH_3)$ gas, a (diisopropylamino)silane $((C_3H_7)_2NSiH_3)$ gas or the like, a monoaminosilane gas such as an ethylmethylamino)silane $(SiH_3(N(CH_3)(C_2H_5)))$ gas, a (dimethylamino)silane $(SiH_3(N(CH_3)_2))$ gas or the like, or a trimethoxydialkylaminosilane gas such as a trimethoxydimethylaminosilane $((CH_3)_2NSi(OCH_3)_3)$ gas or the like, which contains a single amino group bonded to Si. One or more of these gases may be used as the second precursor. Among these gases, it is possible to use, as the second precursor, a gas in which a bonding hand other than bonding hands of Si bonded to the single amino group is bonded to H, such as the $((C_4H_9)_2NSiH_3)$ gas, the $((C_3H_7)_2NSiH_3)$ gas, the $(SiH_3(N(CH_3)(C_2H_5)))$ gas, the $(SiH_3(N(CH_3)_2))$ gas or the like.

In addition, it may be possible to use, as the second precursor, an aminosilane-based gas including a bis(dialkylamino)dialkylsilane gas such as a bis(dimethylamino)dimethylsilane $([(CH_3)_2N]_2Si(CH_3)_2)$ gas or the like, a tris(dialkylamino)alkylsilane gas such as a tris(dimethylamino)methylsilane $([(CH_3)_2N]_3SiCH_3)$ gas or the like, a bis(dialkylamino)silane gas such as a bis(diethylamino)silane $([(C_2H_5)_2N]_2SiH_2)$ or the like, a bis(monoalkylamino)silane gas such as a bis(tert-butylamino)silane $([(C_4H_9)NH]_2SiH_2)$ gas or the like, a tris(dialkylamino)silane gas such as a tris(dimethylami-no)silane $([(CH_3)_2N]_3SiH)$ gas or the like, or a tetrakis(dialkylamino)silane gas such as a tetrakis(dimethylamino)silane $([(CH_3)_2N]_4Si)$ gas or the like, which contains a plurality of amino groups bonded to Si. One or more of these gases may be used as the second precursor.

After the second layer is formed over the surface of the wafer 200 (the inner surface of the recess structure 300), the valve 243c is closed to stop the supply of the precursor into the process chamber 201. Then, the inside of the process chamber 201 is vacuum-exhausted to remove gaseous substances remaining inside the process chamber 201 from the inside of the process chamber 201. At this time, the valves 243d and 243e are opened to supply an inert gas into the process chamber 201 via the nozzles 249a and 249b. The inert gas supplied from the nozzles 249a and 249b acts as a purge gas, thereby purging a space where the wafers 200 exist, i.e., the inside of the process chamber 201.

[Step C]

After step B is completed, an oxidizing agent that oxidizes the second layer is supplied to the wafers 200 in the process chamber 201, i.e., the wafers 200 in which the second layer is formed over the inner surface of the recess structure 300.

Specifically, the valve 243b is opened to allow the oxidizing agent to flow through the gas supply pipe 232b. A flow rate of the oxidizing agent is regulated by the MFC 241b. The oxidizing agent is supplied into the process chamber 201 via the nozzle 249b, and is exhausted via the exhaust port 231a. At this time, the oxidizing agent is supplied to the wafers 200 (supply of oxidizing agent). At this time, the valves 243d and 243e may be opened to supply an inert gas into the process chamber 201 via the nozzles 249a and 249b.

A processing condition when the oxidizing agent is supplied in this step is exemplified as follows:

> Processing temperature: 20 to 700 degrees C, specifically 200 to 600 degrees C, more specifically 500 to 600 degrees C
> Processing pressure: 100 to 10,000 Pa, specifically 1,000 to 10,000 Pa
> Supply flow rate of oxidizing agent: 0.1 to 20 slm, specifically 1 to 10 slm
> Supply time of oxidizing agent: 1 to 120 seconds, specifically 3 to 15 seconds

Other processing conditions may be the same as those used when supplying the first precursor in step A. In this step, it is possible to use a gas (non-plasma gas) that is not plasma-excited (non-plasma state).

By supplying the oxidizing agent to the wafers 200 under the above-described processing conditions at least a portion of the second layer formed over the inner surface of the recess structure 300 is oxidized by reacting with the oxidizing agent. As a result, a third layer, which is an oxide layer of the second layer, is formed over the inner surface of the recess structure 300. The third layer is a layer containing a predetermined element. When the third layer is formed, at least a portion of impurities such as a halogen element and the like contained in the second layer is desorbed from the second layer as gaseous substances during the oxidizing reaction process for the third layer, and is discharged from the inside of the process chamber 201. As a result, the third layer becomes a layer containing fewer impurities such as a halogen element and the like than the second layer formed in step B.

As the oxidizing agent, it may be possible to use an oxygen (O)-containing gas (O-containing substance). As the O-containing gas, it may be possible to use an oxygen $(O_2)$ gas, an ozone $(O_3)$ gas, a nitrous oxide $(N_2O)$ gas, a nitric oxide (NO) gas, a nitrogen dioxide $(NO_2)$ gas, a carbon monoxide (CO) gas, a carbon dioxide $(CO_2)$ gas or the like. One or more of these gases may be used as the oxidizing agent. Further, as the oxidizing agent, it may be possible to use an O- and H-containing gas (an O- and H-containing substance). As the O- and H-containing gas, it may be possible to use a water vapor $(H_2O)$ gas, a hydrogen peroxide $(H_2O_2)$ gas, $H_2$ gas$+O_2$ gas, $H_2$ gas$+O_3$ gas, or the like. That is, as the O- and H-containing gas, O-containing gas+H-containing gas may also be used. In this case, as the H-containing gas, a deuterium $(^2H_2)$ gas may be used instead of the $H_2$ gas. As the oxidizing agent, one or more of these gases may be used. For example, when the above-mentioned aminosilane-based gas is used as the second precursor, and the O-containing gas or the O- and H-containing gas is used as the oxidizing agent, a silicon oxide layer (SiO layer) is formed as the third layer over the surface of the wafer 200.

In the present disclosure, description of two gases together such as "$H_2$ gas$+O_2$ gas" means a mixed gas of

a H$_2$ gas and an O$_2$ gas. When supplying the mixed gas, two gases may be mixed (premixed) in a supply pipe and then supplied into the process chamber 201, or two gases may be separately supplied to the process chamber 201 via different supply pipes and then mixed (post-mixed) within the process chamber 201.

Among the above-described gases, it is possible to use, as the oxidizing agent, the O-containing gas that does not contain H, such as an O$_2$ gas or an O$_3$ gas.

In a case where an oxygen-containing gas that is thermally decomposed with ease is used as the oxidizing agent, when a processing temperature exceeds a specific temperature (e.g., 600 degrees C), the oxidizing agent may be thermally decomposed excessively and the oxidizing power thereof may decrease, thereby making it difficult to oxidize the second layer. By setting the processing temperature to a specific temperature (e.g., 600 degrees C) or lower, it is possible to oxidize the second layer even when such an oxidizing agent is used.

After the second layer formed over the surface of the wafer 200 (the inner surface of the recess structure 300) is modified to the third layer, the valve 243b is closed to stop the supply of the oxidizing agent into the process chamber 201. Then, the inside of the process chamber 201 is vacuum-exhausted to remove gaseous substances remaining inside the process chamber 201 from the inside of the process chamber 201. At this time, the valves 243d and 243e are opened to supply an inert gas into the process chamber 201 via the nozzles 249a and 249b. The inert gas supplied via the nozzles 249a and 249b acts as a purge gas, thereby purging the space where the wafers 200 exist, i.e., the inside of the process chamber 201.

[Performing a Predetermined Number of Times]

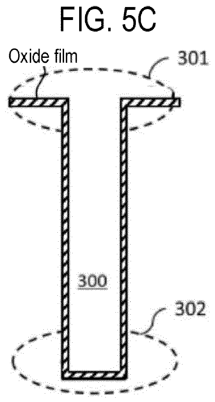

As a cycle of performing the above-described steps A to C non-simultaneously, i.e., without synchronization in this order is performed n times (where n is an integer of 1 or 2 or more), an oxide film with a desired composition is formed over the surface of the wafer 200 (the inner surface of the recess structure 300) *(see* FIG. 5C). Further, by setting the number of cycles n to the number of times by which the inside of the recess structure 300 is filled with an oxide film, the inside of the recess structure 300 is filled with the oxide film. For example, when a gas containing the above-described Si and amino group as the second precursor, a silicon oxide film (SiO film) is formed over the surface of the wafer 200. Specifically, the above-described cycle is performed multiple times. In other words, a thickness of the third layer formed per cycle is set to be smaller than a desired thickness, and the above-mentioned cycle is performed multiple times until a thickness of the oxide film formed by stacking the third layer reaches the desired thickness.

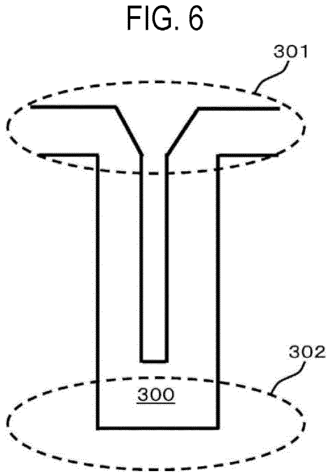

In the embodiments of the present disclosure, the cycle performed at an m-th time (where m is an integer less than n) may be different from the cycle performed at an (m+1)-th time in at least one selected from the group of the supply time, the partial pressure, and the processing pressure of the first precursor in step A, which is executed in the cycle performed at the (m+1)-th time. Specifically, depending on a film thickness distribution of the oxide film at the end of the cycle performed at the m-th time, at least one selected from the group of the supply time, the partial pressure, and the processing pressure of the first precursor in step A executed in the cycle performed at the (m+1)-th time may be different from those of the first precursor in step A executed up to the cycle performed at the m-th time. More specifically, for example, as shown in FIG. 6, in a case where the film thickness distribution (aspect ratio) of the oxide film at the end of the cycle performed at the m-th time is larger than an aspect ratio of the recess structure 300 before the film-forming process, the supply time of the first precursor in step A executed in the cycle performed at the (m+1)-th time may be set to be longer than the supply time of the first precursor in step A executed in the cycle performed at the m-th time, the partial pressure of the first precursor in step A executed in cycle performed at the (m+1)-th time may be set to be higher than the partial pressure of the first precursor in step A executed in the cycle performed at the m-th time, or the processing pressure in step A executed in the cycle performed at the (m+1)-th time may be set to be higher than the processing pressure in step A executed in the cycle performed at the m-th time. As a result, a density of the first layer formed on the upper end of the opening side 301 may be increased. Therefore, it is possible to strengthen a film formation inhibition effect of the first layer, and it is possible to form the second layer from the lower end of the deep side 302 (the bottom surface of the opening) toward the side surface of the opening. As a result, the step coverage may be maintained even when the aspect ratio is increased.

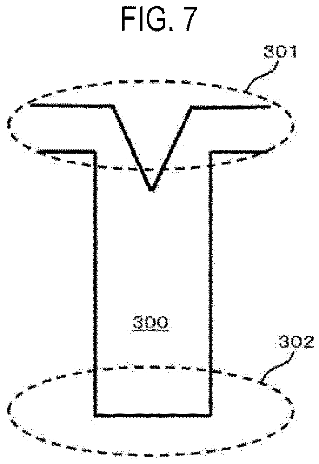

On the other hand, for example, as shown in FIG. 7, in a case where the film thickness distribution (aspect ratio) of the oxide film at the end of the cycle performed at the m-th time is smaller than the aspect ratio of the recess structure 300 before the film-forming process, the supply time of the first precursor in step A executed in the cycle performed at the (m+1)-th time may be set to be shorter than the supply time of the first precursor in step A executed in the cycle performed at the m-th time, the partial pressure of the first precursor in step A executed in the cycle performed at the (m+1)-th time may be set to be lower than the partial pressure of the first precursor in step A executed in the cycle performed at the m-th time, or the processing pressure in step A executed in the cycle performed at the (m+1)-th time may be set to be lower than the processing pressure in step A executed in the cycle performed at the m-th time. Thus, it is possible to reduce the density of the first layer formed on the upper end of the opening side 301, and it is possible to lower the film formation inhibition effect of the first layer. As a result, it is possible to increase the deposition rate of the second layer, and it is possible to improve a throughput in oxide film formation.

Further, as described above, for example, by regulating at least one selected from the group of the supply time, the partial pressure, and the processing pressure of the first precursor in step A, it is possible to control the thickness distribution of the second layer and the oxide film in a depth direction of the recess structure 300.

(After-Purge and Returning to Atmospheric Pressure)

After the film-forming process is completed, an inert gas as a purge gas is supplied into the process chamber 201 via each of the nozzles 249a and 249b, and is exhausted via the exhaust port 231a. As a result, the inside of the process chamber 201 is purged, and gases, reaction byproducts, and the like remaining in the process chamber 201 are removed from the inside of the process chamber 201 (after-purge). Thereafter, the atmosphere inside the process chamber 201 is replaced with the inert gas (inert gas replacement), and the pressure inside the process chamber 201 is returned to the atmospheric pressure (returning to atmospheric pressure).

(Boat Unloading and Wafer Discharging)

Thereafter, the seal cap 219 is lowered by the boat elevator 115, and the lower end of the manifold 209 is opened. The processed wafers 200 are then unloaded from the lower end of the manifold 209 to the outside of the reaction tube 203 while being supported by the boat 217 (boat unloading). After the boat unloading, the shutter 219s is moved and the lower end opening of the manifold 209 is sealed by the shutter 219s via the O-ring 220c (shutter closing). The processed wafers 200 are discharged from the boat 217 after being unloaded to the outside of the reaction tube 203 (wafer discharging).

(3) Effects of the Present embodiment

According to the embodiments of the present disclosure, one or more of the following effects may be obtained.

(a) In step B, by using the second precursor containing an amino group (e.g., aminosilane-based gas), it becomes easy to realize a higher deposition rate than when using a precursor not containing an amino group (e.g., halosilane-based gas).

In step B, by using the second precursor containing a single amino group, which is relatively easy to react with the halogen element terminating the first layer, in one molecule, it is possible to minimize the desorption of the halogen element terminating the first layer. This makes it possible to enhance an inhibitor effect of inhibiting the adsorption of the predetermined element to the first layer, as compared with a case of using a precursor containing a plurality of amino groups in one molecule. As a result, it is possible to improve the step coverage of the oxide film formed over the inner surface of the recess structure of the wafer 200.

Since the second precursor contains a single amino group in one molecule, when the predetermined element contained in the second precursor is adsorbed to the surface of the wafer 200 in step B, it is possible to reduce an amount of residual amino groups remaining in the second layer without being desorbed. This makes it difficult for impurities (C or N) derived from amino groups to remain in the oxide film.

Furthermore, in step A, by forming the first layer by using a precursor containing a predetermined element as the first precursor, it is possible to increase the adsorption rate of the precursor (the deposition rate of the first layer), as compared with a case of forming the first layer by using a compound composed of a halogen element,. Thus, it is possible to shorten the time to form the first layer. In addition, by forming the first layer containing a predetermined element, the predetermined element contained in the first layer, which acts as an adsorption-inhibiting layer (inhibitor layer) for the second precursor, may also make contribution as a portion of the oxide film, which makes it possible to improve the deposition rate of the oxide film.

(b) step B is executed under the processing condition in which the predetermined element contained in the second precursor may be adsorbed to the wafer 200 by supplying the second precursor to the wafer 200 over which the first layer is not formed. In other words, step B is performed under the processing condition that allow the predetermined element contained in the second precursor to be adsorbed to the wafer 200 without executing step A, for example, the processing condition at higher temperature and pressure than the condition under which the predetermined element contained in the second precursor may not be adsorbed to the surface of the wafer 200 over which the first layer is not formed. Thus, in step B, the predetermined element may be adsorbed to the adsorption sites on the surface of the wafer 200 in a state in which the first layer inhibits the adsorption of the predetermined element contained in the second precursor.

(c) By setting the partial pressure of the second precursor supplied to the wafer 200 in step B to be higher than the partial pressure of the first precursor supplied to the wafer 200 in step A, i.e., by supplying the second precursor containing a predetermined element and an amino group at a relatively high partial pressure, the second precursor may be easily activated and the amino group may be easily desorbed from the second precursor. This makes it possible to promote adsorption of the predetermined element containing dangling bonds to the wafer 200, thereby increasing the deposition rate. The same applies to a case where the processing pressure in step B is set to be higher than the processing pressure in step A.

By setting the partial pressure of the first precursor supplied to the wafer 200 in step A to be lower than the partial pressure of the second precursor supplied to the wafer 200 in step B, i.e., by supplying the first precursor at a relatively low partial pressure, it is possible to suppress excessive thermal decomposition of the first precursor, and it is possible to avoid a decrease in the step coverage due to local multiple deposition of the predetermined element near the upper end of the recess structure 300 on the wafer 200. The same applies to a case where the processing pressure in step A is lower than the processing pressure in step B.

(d) By using a gas containing the bond between the predetermined elements in one molecule as the first precursor, the bond between the predetermined elements may be broken by thermal decomposition or the like, and a highly reactive intermediate containing a halogen element and dangling bonds of the predetermined element may be produced with ease. This may promote the formation of a first layer terminated with the halogen element over the surface of the wafer 200. Specifically, when an OH termination is formed at the surface of the oxide film, the formation of the first layer may be easily promoted by producing such an intermediate. This is because when step C is executed and OH terminations are formed at the surface of the oxide film, these OH terminations function as adsorption sites. Further, this is because the intermediate containing the predetermined element, which contains the dangling bond produced from the first precursor in step A of the next cycle, is highly reactive to react with these OH terminals and cause adsorption of the predetermined element bonded to the halogen element. On the other hand, step A may be performed under a higher temperature condition or a higher pressure condition to generate the above-described highly reactive intermediate when using a gas not containing the bond between the predetermined elements in one molecule as the first precursor. Further, even when using a gas containing the halogen element but not containing the predetermined element as a modifying agent, a higher temperature condition or a higher pressure condition may be demanded for bringing the gas into a state of being highly reactive as described above.

(e) In step A, by supplying the first precursor under the processing condition in which the bond between the predetermined elements is broken in the gas phase, the highly reactive intermediate containing the halogen element and containing the dangling bond of the predetermined element may be generated in the gas phase. This may promote the formation of the first layer over the surface of the wafer 200 for the same reasons as described above.

(f) By using a gas not containing H in one molecule as the first precursor, it is possible to suppress H terminations with a low adsorption inhibition effect from being formed at the surface of the first layer. As a result, it is possible to reliably suppress multiple adsorption of the predetermined element contained in the second precursor to the first layer, thereby preventing deterioration of the step coverage.

(g) By using a gas, in which the bonding hand other than the bonding hand of the predetermined element bonded to the single amino group is bonded to H, as the second precursor, it is possible to increase the density of the predetermined element in the second layer. When the second precursor is adsorbed to the surface of the wafer 200, in a case where another ligand with a larger molecular weight than H is bonded to the predetermined element, such a ligand may act as a steric hindrance and may inhibit an adsorption of another predetermined element contained in the second precursor to the adsorption sites on the surface of the wafer 200. Therefore, the density of the second layer may decrease. On the other hand, by using H as the ligand for the predetermined element, the predetermined element contained in the second precursor may be adsorbed well to the adsorption site on the surface of the wafer 200, which makes it possible to increase the density of the predetermined element in the second layer. Further, by increasing the density of the predetermined element in the second layer, it is possible to increase the deposition rate of the oxide film. Moreover, when the second precursor is adsorbed to the surface of the wafer 200, elements (C, etc.) other than H contained in the second precursor may be prevented from remaining in the oxide film while being bonded to the predetermined element. That is, it is possible to reduce impurities derived from the ligand in the oxide film.

(h) By using an O-containing gas that does not contain H as the oxidizing agent, i.e., by not supplying the H-containing gas in step C, the halogen element constituting the halogen terminations remaining on the surface of the first layer may be prevented from being desorbed by reacting with H. Thus, in step B of the next cycle, it is possible to improve the adsorption inhibition effect of suppressing adsorption of the predetermined element contained in the second precursor to the surface of the first layer. In a case where priority is given to reducing the halogen element concentration in the oxide film over the adsorption inhibition effect of the first layer, it may be possible to use an O-containing gas containing H as the oxidizing agent.

(i) By performing step C by using a gas that is not excited by plasma (i.e., non-plasma gas), it is possible to suppress desorption of the halogen element constituting the halogen terminations remaining on the surface of the first layer. The non-plasma gas includes, for example, a thermally-excited gas. Therefore, in step B of the next cycle, it is possible to improve the adsorption inhibition effect of suppressing adsorption of the predetermined element contained in the second precursor to the surface of the first layer. Specifically, when step C is performed by using a plasma-excited gas, the halogen element constituting the halogen terminations remaining on the surface of the first layer is rapidly desorbed. Therefore, it may be difficult to regulate a desorption amount of the halogen element. Accordingly, by performing step C by using a non-plasma gas, the desorption amount of the halogen element constituting the halogen terminations remaining on the surface of the first layer may be regulated, and an adsorption amount of the predetermined element contained in the second precursor to the surface of the first layer may be controlled in step B of the next cycle. In a case where priority is given to reducing the halogen element concentration in the oxide film over the adsorption inhibition effect of the first layer, it may be possible to use the oxidizing agent in a plasma-excited state.

(j) In step A, the first layer is formed such that the density of the first layer formed on the opening side 301 of the recess structure 300 is larger than the density of the first layer formed on the deep side 302. Thus, as compared with a case where the first layer is not formed, the deposition rate of the oxide film over the surface of the deep side 302 may be made greater than the deposition rate of the oxide film over the surface of the opening side 301. That is, by forming the first layer in this manner, as compared with a case where the first layer is not formed, a thickness distribution of the oxide film may be controlled to increase the deposition rate of the oxide film over the surface of the deep side 302 and reduce the deposition rate of the oxide film over the surface of the opening side 301. For example, the thickness distribution of the second layer may be controlled such that the deposition rate of the oxide film over the surface of the deep side 302 is greater than the deposition rate of the oxide film over the surface of the opening side 301, or the deposition rate of the oxide film over the surface of the deep side 302 and the deposition rate of the oxide film over the surface of the opening side 301 are substantially equal to each other. As a result, it is possible to improve the step coverage of the oxide film formed over the inner surface of the recess structure 300.

(4) Modifications

The processing sequence according to the embodiments of the present disclosure may be modified as shown in the following modifications. These modifications may be combined arbitrarily. Unless otherwise specified, a processing procedure and a processing condition in each step of each modification may be the same as the processing procedure and processing condition in each step of the processing sequence described above.

(First Modification)

As in the processing sequence shown below, steps A, B, and C may be performed in this order while an execution period of step A and an execution period of step B overlap each other at least partially.

(first precursor → first precursor + second precursor → second precursor → purging → oxidizing agent → Purging) × n

In the first modification, in addition to the above-mentioned effects, a cycle time may be shortened and a productivity of the film-forming process may be improved.

(Second Modification)

As in the processing sequence shown below, a first cycle including steps A, B, and C may be performed a first number of times (n1 times where n1 is an integer of 1 or 2 or more), and then a second cycle not including step A but including step B and Step C may be performed a second number of times (n2 times where n2 is an integer of 1 or 2 or more). For example, in a case where an aspect ratio of the recess structure 300 at the end of the cycle performed at the n1-th time is decreased as shown in FIG. 7, a cycle that does not include step A may be performed in the subsequent film-forming process.

(first precursor → purging → secondd precursor → purging → oxidizing agent → purging) × n1 → (second precursor → purging → oxidizing agent → purging) × n2

In the second modification, the above-described effects may be obtained. Further, since the number of execution times of step A is reduced as compared to the number of execution times of steps B and C, the cycle time may be shortened and the productivity of the film-forming process may be improved.

(Third Modification)

As in the processing sequence shown below, steps B and C may be performed multiple times in each cycle. For example, while the adsorption inhibition effect of the first layer is maintained, a film may be formed through a cycle of step B and step C without performing step A (formation of the first layer).

[first precursor → purging → (second precursor → purging → oxidizing agent → purging) × n3] × n4 (where n3 is an integer of 2 or more, and n4 is an integer of 1 or 2 or more)

In the third modification, the above-described effects may be obtained. Furthermore, since the number of execution times of step A is reduced as compared with the number of execution times of steps B and C, the cycle time may be shortened and the productivity of the film-forming process may be improved.

(Fourth Modification)

As in the processing sequence shown below, the purging performed after step A may be omitted.

$$(\text{first precursor} \rightarrow \text{second precursor} \rightarrow \text{purging} \rightarrow \text{oxidizing agent} \rightarrow \text{purging}) \times n$$

In the fourth modification, purging is performed between step B and step C. Therefore, while suppressing generation of particles due to a reaction between the second precursor and the oxidizing agent and avoiding deterioration of a film quality, in addition to the above-described effects, the cycle time may be shortened and the productivity of the film-forming process may be improved.

<Other Embodiments of the Present Disclosure>

The embodiments of the present disclosure are specifically described above. However, the present disclosure is not limited to the above-described embodiments, and various changes may be made without departing from the gist of the present disclosure.
For example, in the above-described embodiments, the examples are described in which the predetermined element contained in the first precursor or the second precursor is Si. However, the present disclosure is not limited to such embodiments. For example, the predetermined element may also be a metal element such as titanium (Ti), zirconium (Zr), hafnium (Hf), tantalum (Ta), niobium (Nb), aluminum (Al), molybdenum (Mo), tungsten (W), germanium (Ge) or the like. In such cases, a metal-based oxide film such as a titanium oxide film (TiO film), a zirconium oxide film (ZrO film), a hafnium oxide film (HfO film), a tantalum oxide film (TaO film), a niobium oxide film (NbO film), an aluminum oxide film (AlO film), a molybdenum oxide film (MoO film), a tungsten oxide film (WO film), a germanium oxide film (GeO film) or the like is formed. In such cases as well, the same effects as those of the above-described embodiments may be obtained.
For example, in the above-described embodiments of the present disclosure, the case where the Si film is formed as a base over the surface of the wafer 200 is described. However, the present disclosure is not limited to such embodiments. For example, an oxide film such as a SiO film or a nitride film such as a SiN film may be formed as a base over the surface of the wafer 200. In such cases as well, the same effects as those of the above-described embodiments may be obtained.
As an example, a step coverage of the oxide film formed over the inner surface of the recess structure 300 may be determined by substituting a thickness $T_{TOP}$ of a film formed at a top (edge) in the recess structure 300 and a thickness $T_{BOT}$ of a film formed over a bottom surface in the recess structure 300 into the following formula (1).

$$\text{step coverage } (\%) = [T_{BOT}/T_{TOP}] \times 100 \ \cdots \ (1)$$

However, the step coverage in the present disclosure is not limited to the one calculated by such a calculation method, but may include other characteristics related to uniformity of a thickness of a film formed at a step of a three-dimensional structure such as the recess structure 300 or the like, and other indicators indicating the same. Further, the improvement in step coverage is not limited to the case where the thickness of the film formed at the step is nearly uniform, but may include the improvement of further increasing the film thickness at the bottom in the recess structure as compared with the film thickness at the top in the recess structure (e.g., a case where the step coverage calculated by formula (1) approaches a desired value in a range exceeding 100%) when a film may be formed in such a way that a film thickness increases from the top toward the bottom in the recess structure as in bottom-up deposition for the recess structure.

Recipes used in each process may be provided individually according to contents of the process, and recorded and stored in the memory 121c via a telecommunications line or the external memory 123. Then, when starting each process, the CPU 121a may appropriately select an appropriate recipe from among a plurality of recipes recorded and stored in the memory 121c according to the contents of the process. This makes it possible to form films of various film types, composition ratios, film qualities, and film thicknesses with good reproducibility by using a single substrate processing apparatus. In addition, burden on the operator may be reduced, and each process may be started quickly while avoiding operational errors.

The above-described recipes are not limited to newly-provided ones but may be provided, for example, by modifying existing recipes that are already installed in the substrate processing apparatus. When the recipes are modified, the modified recipes may be installed in the substrate processing apparatus via a telecommunications line or a recording medium storing the recipes. In addition, the existing recipes already installed in the existing substrate processing apparatus may be directly modified by operating the input/output device 122 of the substrate processing apparatus.

An example in which a film is formed by using a batch-type substrate processing apparatus capable of processing a plurality of substrates at a time is described in the above-described embodiments. The present disclosure is not limited to the above-described embodiments, but may be suitably applied, for example, to a case where a film is formed by using a single-wafer type substrate processing apparatus capable of processing a single substrate or several substrates at a time. In addition, an example in which a film is formed by using a substrate processing apparatus including a hot-wall-type process furnace is described in the above-described embodiments. The present disclosure is not limited to the above-described embodiments, but may also be suitably applied to a case where a film is formed by using a substrate processing apparatus including a cold-wall-type process furnace.

Even in the case of using these substrate processing apparatuses, each process may be performed according to the same processing procedures and processing conditions as those in the above-described embodiments and modifications, and the same effects as the above-described embodiments and modifications are achieved.

The above-described embodiments and modifications may be used in proper combination. The processing procedures and processing conditions used in this case may be the same as, for example, the processing procedures and processing conditions in the above-described embodiments and modifications.

According to the present disclosure in some embodiments, it is possible to improve a step coverage of a film formed over a substrate.

While certain embodiments are described above, these embodiments are presented by way of example, and are not intended to limit the scope of the disclosures. Indeed, the embodiments described herein may be embodied in a variety of other forms. Furthermore, various omissions, substitutions, and changes in the form of the embodiments described herein may be made without departing from the spirit of the disclosures. The accompanying claims and their equivalents are intended to cover such forms or modifications as would fall within the scope and spirit of the disclosures.

**Claims**

1. A method of processing a substrate (200), comprising:
   forming an oxide film containing a predetermined element over the substrate (200) by performing a first cycle a first predetermined number of times, the first cycle including:

   (a) forming a first layer containing the predetermined element terminated with a halogen element over the substrate (200) by supplying a first precursor containing the predetermined element and the halogen element to the substrate (200);
   (b) forming a second layer containing the predetermined element over the substrate (200) by supplying a second precursor containing the predetermined element and a single amino group bonded to the predetermined element in one molecule to the substrate (200) over which the first layer is formed; and
   (c) oxidizing the second layer by supplying an oxidizing agent to the substrate (200) over which the second layer is formed.

2. The method of Claim 1, wherein the oxide film is formed at an inner surface of a recess structure (300) provided at a surface of the substrate (200).

3. The method of Claim 1, wherein a partial pressure of the second precursor supplied to the substrate (200) in (b) is greater than a partial pressure of the first precursor supplied to the substrate (200) in (a).

4. The method of Claim 3, wherein a pressure in a space where the substrate (200) exists in (b) is greater than a pressure in the space where the substrate (200) exists in (a).

5. The method of Claim 1, wherein the first precursor is a gas containing a bond between two elements in one molecule, wherein the two elements are both the predetermined element.

6. The method of Claim 5, wherein the first precursor is a gas that does not contain hydrogen in the one molecule.

7. The method of Claim 1, wherein among bonding hands of the predetermined element constituting the second precursor, a bonding hand other than a bonding hand bonded to the single amino group is bonded to hydrogen.

8. The method of Claim 1, wherein the oxidizing agent is an oxygen-containing gas that does not contain hydrogen.

9. The method of Claim 1, wherein in (b), the second layer is formed over the substrate (200) by allowing the predetermined element, which contains a dangling bond due to desorption of the single amino group from a molecule of the second precursor, to be adsorbed to an adsorption site on a surface of the substrate (200) over which the first layer is not formed.

10. The method of Claim 2, wherein in (a), the first layer is formed such that a density of the first layer formed at an upper end of a side surface of the recess structure (300) is larger than a density of the first layer formed at a bottom end of the side surface of the recess structure (300).

11. The method of Claim 1, further comprising:
performing a second cycle not including (a) but including (b) and (c) a second predetermined number of times.

12. The method of Claim 1, wherein in the first cycle, (b) and (c) are executed multiple times.

13. A method of manufacturing a semiconductor device, comprising:
forming an oxide film containing a predetermined element over a substrate (200) by performing a cycle a predetermined number of times, the cycle including:

(a) forming a first layer containing the predetermined element terminated with a halogen element over the substrate (200) by supplying a first precursor containing the predetermined element and the halogen element to the substrate (200);
(b) forming a second layer containing the predetermined element over the substrate (200) by supplying a second precursor containing the predetermined element and a single amino group bonded to the predetermined element in one molecule to the substrate (200) over which the first layer is formed; and
(c) oxidizing the second layer by supplying an oxidizing agent to the substrate (200) over which the second layer is formed.

14. A program that causes, by a computer, a substrate processing apparatus perform a process comprising:
forming an oxide film containing a predetermined element over a substrate (200) by performing a cycle a predetermined number of times, the cycle including:

(a) forming a first layer containing the predetermined element terminated with a halogen element over the substrate (200) by supplying a first precursor containing the predetermined element and the halogen element to the substrate (200);
(b) forming a second layer containing the predetermined element over the substrate (200) by supplying a second precursor containing the predetermined element and a single amino group bonded to the predetermined element in one molecule to the substrate (200) over which the first layer is formed; and
(c) oxidizing the second layer by supplying an oxidizing agent to the substrate (200) over which the second layer is formed.

15. A substrate processing apparatus, comprising:

a first precursor supply system configured to supply a first precursor containing a predetermined element and a halogen element to a substrate (200);
a second precursor supply system configured to supply a second precursor containing the predetermined element and a single amino group bonded to the predetermined element in one molecule to the substrate (200); an oxidizing agent supply system configured to supply an oxidizing agent to the substrate (200); and a controller (121) configured to be capable of controlling the first precursor supply system, the second precursor supply system, and the oxidizing agent supply system to perform:

forming an oxide film containing the predetermined element over the substrate (200) by performing a cycle a predetermined number of times, the cycle including:

(a) forming a first layer containing the predetermined element terminated with the halogen element over the substrate (200) by supplying the first precursor to the substrate (200);
(b) forming a second layer containing the predetermined element over the substrate (200) by supplying the second precursor to the substrate (200) over which the first layer is formed; and
(c) oxidizing the second layer by supplying the oxidizing agent to the substrate (200) over which the second layer is formed.

# FIG. 1

# FIG. 2

# FIG. 3

# FIG. 4

# FIG. 5A

First precursor

301

300

302

# FIG. 5B

First precursor

301

Second precursor

300

302

# FIG. 5C

Oxide film 301

300

302

FIG. 6

FIG. 7

301

300

302

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2023047530 A